# EUROPÄISCHE PATENTANMELDUNG

(11) **EP 1 401 103 A1**
(43) Veröffentlichungstag der Anmeldung: **24.03.2004**
(21) Anmeldenummer: 03101733.8
(22) Anmeldetag: 13.06.2003
(51) Int. Cl.: H03L 7/093

(54) **Schaltungsanordnung und Verfahren zum Abstimmen der Oszillationsfrequenz**

(30) Priorität: 19.09.2002 DE 10243503
(71) Anmelder: ROBERT BOSCH GMBH, 70442 Stuttgart (DE)
(72) Erfinder: Wermuth, Juergen, 31224, Peine (DE)

(57) **Zusammenfassung**

Um eine Schaltungsanordnung (100; 100') sowie ein Verfahren zum Abstimmen der Oszillationsfrequenz in mindestens einer Empfangseinheit so weiterzuentwickeln, daß die gegebene, in der Praxis aus verschiedenen Gründen (Fertigungsabgleich, konstantes Temperaturverhalten der Schwingkreise untereinander, ...) nicht veränderbare Abstimmkennlinie (K1) für sehr schnell einschwingende P[hase]L[ocked]L[oop]-Empfangssysteme linearisiert wird, wird vorgeschlagen, daß mindestens einem Phasenregelkreis, insbesondere mindestens einem P[hase]L[ocked]L[oop]-Regelkreis, mindestens eine Linearisierungsschaltung zugeordnet, insbesondere nachgeschaltet, wird, mittels derer die insbesondere als aus Empfangsfrequenz (f) und Spannung (U) des Abstimmsignals gebildeter Differentialquotient gegebene Abstimmkennlinie linearisiert wird.

## Beschreibung

### Technisches Gebiet

Die vorliegende Erfindung betrifft eine zum Abstimmen der Oszillationsfrequenz in mindestens einer Empfangseinheit vorgesehene Schaltungsanordnung, aufweisend mindestens einen Phasenregelkreis, insbesondere mindestens einen P[hase]L[ocked]L[oop]-Regelkreis, mit mindestens einer Operationsverstärkereinheit.

Des weiteren betrifft die vorliegende Erfindung ein einer derartigen Schaltungsanordnung zugeordnetes Verfahren zum Abstimmen der Oszillationsfrequenz in mindestens einer Empfangseinheit.

Im speziellen bezieht sich die vorliegende Erfindung auf die P[hase]L[ocked]L[oop]-Problematik insbesondere bei F[requenz]M[odulation]-Empfängereinrichtungen, vor allem bei Anwendungen für Autoradios (--> schnelle A[lternative]F[requency]-Tests).

### Stand der Technik

Rundfunkempfänger (auf A[mplituden]M[odulation]-Basis und/oder auf F[requenz]M[odulation]-Basis) bedienen sich heutzutage zur Frequenzabstimmung des Oszillators sogenannter P[hase]L[ocked]L[oop]-Systeme; dies bedeutet, daß in heutigen Empfängersystemen die Oszillationsfrequenz mittels eines Phasenregelkreises (= sogenanntes P[hase]L[ocked]L[oop]-System) eingestellt wird. In diesem Zusammenhang ist es gerade in Autoradioempfängern erforderlich, die momentane "Senderlandschaft" genau zu kennen, um im Bedarfsfalle, das heißt bei schlechtem Empfang automatisch und schnell einen Frequenzwechsel durchführen zu können.

Während des Empfangs sind also ständig andere Sender durch sogenannte A[lternative]F[requency]-Tests auf Feldstärke, auf Güte und auf dergleichen zu kontrollieren. Um diese Vorgänge unhörbar zu machen, sind derartige Kontrollen so kurz wie möglich zu gestalten, wobei eine Dauer von etwa einer Millisekunde anzustreben ist; derzeit werden konventionellerweise etwa sieben Millisekunden - für "Mute", für Frequenzsprung, für Messung, für Rücksprung und für "Demute" - benötigt.

Der Frequenzsprung selbst dauert etwa ein bis zwei Millisekunden; dann ist das PLL-System, das heißt die phasenstarre bzw. phasenverriegelte Schleife eingeschwungen. Um ein PLL-System auf Schnelligkeit zu optimieren (sogenannter aperiodischer Grenzfall), ist es erforderlich, die Verstärkungen des Phasenregelkreises zu kennen und mithin zu dimensionieren.

Da sich aber die sogenannte Abstimmsteilheit, das heißt die Frequenz in Abhängigkeit von der Steuerspannung, über den Frequenzbereich (von 87,5 Megahertz bis 108 Megahertz) des F[requenz]M[odulation]-Bands von etwa 7,5 Megahertz/Volt auf etwa 2,5 Megahertz/Volt ändert, ist dies nicht zu erreichen; in diesem Zusammenhang liegt die Nichtlinearität hauptsächlich in den Abstimmdioden - den sogenannten "Kapazitätsdioden" - im Oszillatorschwingkreis begründet.

Damit nun stets ein aperiodischer Einschwingvorgang erfolgt (ein Überschwingen führt zu noch längeren Einschwingzeiten), ist mit einer Abstimmsteilheit von 7,5 Megahertz/Volt zu dimensionieren; dies bedeutet jedoch ein langsameres Gesamtsystem der P[hase]L[ocked]L[oop] (Regelkreisverstärkung = 1).

Die Funktionsweise eines derartigen PLL-Systems ist hierbei in vereinfachter Weise wie folgt: Die Spannung an einem Kondensator wird über einen Widerstand zu einer Kapazitätsdiode im Oszillatorschwingkreis weitergeleitet, um die Frequenz abzustimmen.

Des weiteren wird von einem konstanten Quarzoszillator, zum Beispiel mit einer Schwingungsfrequenz von vier Megahertz, durch digitale Frequenzteilung ein Referenztakt von 12,5 Kilohertz (oder auch von fünfzig Kilohertz) erzeugt. Ferner wird durch einen anderen vorgegebenen, veränderbaren digitalen Frequenzteiler die Frequenz des abgestimmten Oszillators auf 12,5 Kilohertz (oder auch auf fünfzig Kilohertz) geteilt.

In einem Phasenvergleicher werden die beiden geteilten Frequenzen verglichen:

Eilt der Oszillatortakt dem Referenztakt voraus, so fließt für die Zeit der Phasendifferenz ein konstanter Strom von zum Beispiel zwei Milliampere, der die Spannung am Kondensator entlädt und damit die Oszillationsfrequenz verringert.

Eilt der Oszillatortakt hingegen nach, so fließt der Strom in umgekehrter Richtung. Durch die vorgegebene Referenzfrequenz von 12,5 Kilohertz kommt es alle achtzig Mikrosekunden (bei fünfzig Kilohertz entsprechend alle zwanzig Mikrosekunden) zu einem Phasenvergleich mit entsprechend gerichtetem Stromfluß.

Ist nun das PLL-System richtig dimensioniert (Abstimmsteilheit, Kapazität und Strom), so schwingt das PLL-System ein, das heißt es gibt keine Phasendifferenz (<--> kein Stromfluß) und damit auch keine Frequenzdifferenz zwischen den geteilten Frequenzen. Soll nun eine andere Oszillationsfrequenz eingestellt werden, so ist der Frequenzteiler des abstimmbaren Oszillators zu verändern und der PLL-Regelkreis ist neu einzuschwingen. Dieser Vorgang funktioniert natürlich auch mittels Ändern des Referenzteilers oder mittels Ändern sowohl des Frequenzteilers als auch des Referenzteilers.

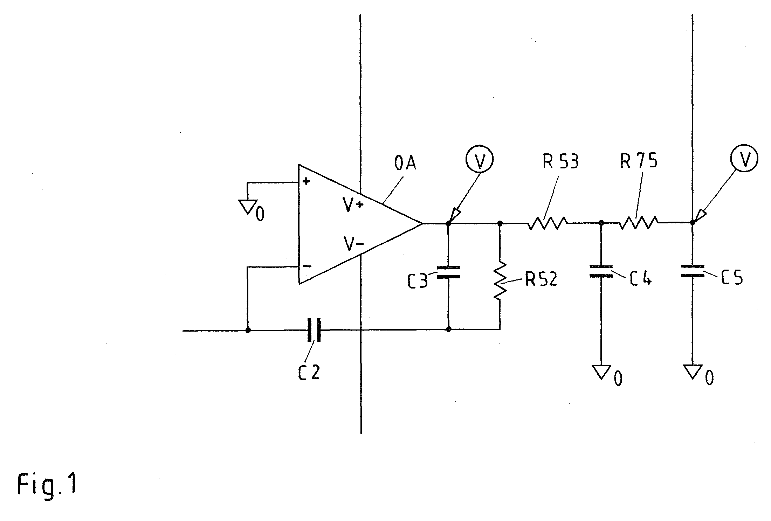

Um in der Praxis ein schnelles Einschwingen und gleichwohl ein sauberes "Halten" der neuen Frequenz zu erreichen, wird konventionellerweise anstelle des vorbeschriebenen Kondensators gemäß dem Stand der Technik ein sogenanntes "Schleifenfilter" eingesetzt. Ein derartiges PLL-Schleifenfilter aus dem Stand der Technik ist exemplarisch in Figur 1 dargestellt.

Der Kondensator C2 (mit einer Kapazität von zum Beispiel etwa 68 Nanofarad) aus Figur 1 entspricht in etwa dem vorbeschriebenen Kondensator und sorgt für die Stabilität im eingeschwungenen Zustand des PLL-Systems. Der Korrekturstrom des Phasenvergleichers setzt am negativen (= "-") Eingangsanschluß des Operationsverstärkers OA an.

Der Kondensator C3 (mit einer Kapazität von zum Beispiel etwa 4,7 Nanofarad) und der zu diesem Kondensator C3 parallel geschaltete Widerstand R52 (= zum Beispiel etwa 5,6 Kiloohm) sind für ein schnelleres Einschwingen bei größeren Frequenzänderungen (--> Phasenrand) vorgesehen.

Der Widerstand R53 (= zum Beispiel etwa zehn Kiloohm) und der diesem Widerstand R53 nachgeschaltete Kondensator C4 (mit einer Kapazität von zum Beispiel etwa einem Nanofarad) bilden ein sogenanntes "Nachfilter"; der dem Widerstand R53 nachgeschaltete Widerstand R75 (= zum Beispiel etwa 6,8 Kiloohm) verteilt die Abstimmspannung auf die Kapazitätsdioden (der Kondensator C5 (Kapazitätsdiode) hat zum Beispiel eine Kapazität von etwa 270 Picofarad).

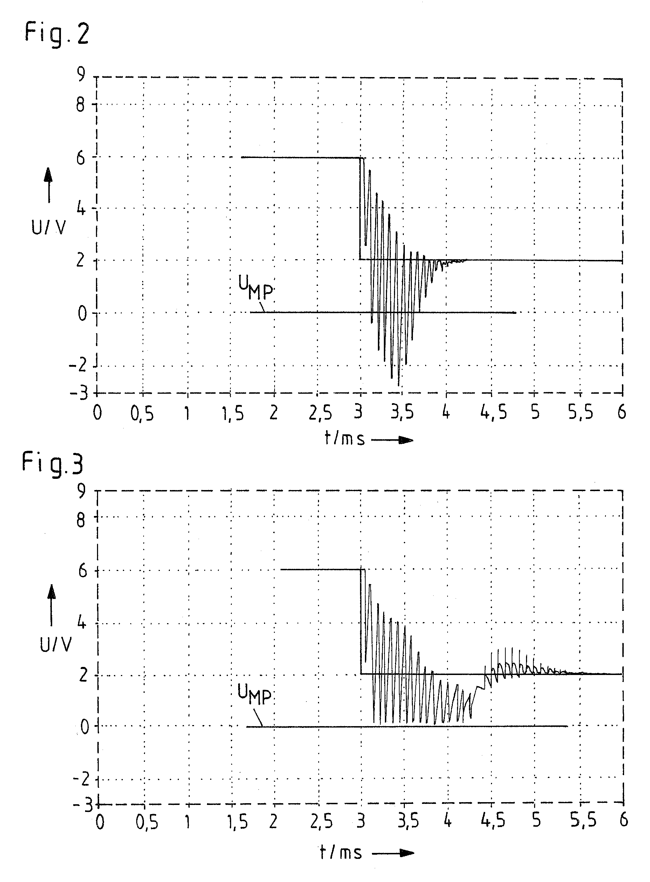

Das anhand Figur 1 veranschaulichte Schleifenfilter arbeitet in einer P[hase]L[ocked]L[oop] mit einem Referenztakt von etwa 12,5 Kilohertz und mit einem Pumpstrom von etwa zwei Milliampere. Dargestellt in Figur 2 ist ein Einschwingvorgang bei einem Frequenzsprung von 108 Megahertz auf 87,5 Megahertz Empfangsfrequenz.

In diesem Zusammenhang ist Figur 2 deutlich entnehmbar, daß Spannungsspitzen bis etwa -3 Volt erforderlich sind, und dies schon bei einer Einschwingzeit von etwa 1,5 Millisekunden; bei viel kürzeren Einschwingzeiten sind entsprechend noch erheblich größere Spannungen für das Einschwingsignal erforderlich.

Wird eine praktische Abstimmkennlinie vorausgesetzt (etwa sechs Volt für 108 Megahertz und etwa zwei Volt für 87,5 Megahertz), so bedeutet dies, daß dem Signal etwa drei Volt fehlen, weil die niedrigste Spannung in der Praxis null Volt (= Massepotential U_{MP}) ist.

Wird der gleiche Frequenzsprung mit einer der Praxis entsprechenden Spannungsbegrenzung und mit nichtlinearer Abstimmkennlinie, das heißt mit Abstimmverzerrung realisiert, so resultiert dies in einer Sprungantwort gemäß Figur 3. Es ist in Figur 3 deutlich zu erkennen, daß sich eine Verlängerung der Einschwingzeit auf etwa 2,5 Millisekunden ergibt, wobei der Einschwingvorgang nach diesem Zeitraum von 2,5 Millisekunden noch gar nicht vollständig beendet ist, sondern immer noch ein leichtes Überschwingen erfolgt.

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung sowie ein Verfahren der eingangs genannten Art so weiterzuentwickeln, daß die gegebene, in der Praxis aus verschiedenen Gründen (Fertigungsabgleich, konstantes Temperaturverhalten der Schwingkreise untereinander, ...) nicht veränderbare Abstimmkennlinie für sehr schnell einschwingende P[hase]L[ocked]L[oop]-Empfangssysteme linearisiert wird.

Diese Aufgabe wird durch eine Schaltungsanordnung mit den im Anspruch 1 angegebenen Merkmalen sowie durch ein Verfahren mit den im Anspruch 8 angegebenen Merkmalen gelöst. Vorteilhafte Ausgestaltungen und zweckmäßige Weiterbildungen der vorliegenden Erfindung sind in den jeweiligen Unteransprüchen gekennzeichnet.

Mithin ist der Kern der vorliegenden Erfindung in der Bereitstellung eines schnellen Empfänger-P[hase]L[ocked]L[oop]-Abstimmlinearisierers sowie eines entsprechend zugeordneten Verfahrens zum Abstimmen der Oszillationsfrequenz zu sehen. Dies wird erfindungsgemäß dadurch erzielt, daß die gegebene, in der Praxis aus verschiedenen Gründen (Fertigungsabgleich, konstantes Temperaturverhalten der Schwingkreise untereinander, ...) nichtlineare Abstimmkennlinie für sehr schnell einschwingende PLL-Empfangssysteme durch eine entsprechende Schaltung linearisiert wird.

Diese in den Unteransprüchen gekennzeichnete Linearisierungsschaltung (= Abstimmentzerrer für F[requenz]M[odulation]-Band) wird hinter das sogenannte Schleifenfilter (Loopfilter) gesetzt und sorgt dafür, daß das P[hase]L[ocked]L[oop]-System im gesamten F[requenz]M[odulation]-Band auf den aperiodischen Grenzfall dimensioniert wird. Hierdurch können deutlich kürzere Einschwingzeiten erreicht werden.

Wird die vorliegende Erfindung für einen Empfänger beispielsweise bei einer Referenzfrequenz von fünfzig Kilohertz für ein sehr schnelles P[hase]L[ocked]L[oop]-System genutzt, so sind PLL-Einschwingzeiten von weniger als etwa 0,2 Millisekunden - anstelle von konventionellerweise 2,5 Millisekunden - möglich, das heißt es ist eine Verkürzung der PLL-Einschwingzeiten um mehr als den Faktor 12 erzielbar.

Die Vorgehensweise bei der Realisierung der Linearisierung ist folgendermaßen:

Es wird zunächst die nichtlineare, vorzugsweise als Differentialquotient aus Empfangsfrequenz und Spannung des Abstimmsignals gegebene Abstimmkennlinie eines gegebenen Empfängers aufgenommen, und zwar nach Möglichkeit sogar um etwa ein Volt über die Bandgrenzen hinaus; sodann wird die Umkehrfunktion gebildet.

Diese Umkehrfunktion (= praktischerweise die Linearisierung der Abstimmkennlinie) wird durch entsprechende Dimensionierung
- mindestens eines zweiten Widerstandselements,
- mindestens eines dritten Widerstandselements,
- mindestens eines vierten Widerstandselements,
- mindestens eines fünften Widerstandselements,
- mindestens eines sechsten Widerstandselements und
- mindestens eines siebten Widerstandselements
in der Linearisierungsschaltung nachgebildet, wobei in den meisten Fällen nur eine leichte Anpassung der Widerstandswerte erforderlich ist.

Während des Betriebs der Linearisierungsschaltung gemäß der vorliegenden Erfindung befinden sich mindestens zwei, vorzugsweise vier der Linearisierungsschaltung zugeordnete Transistoreinheiten in zweckmäßiger Weise etwa auf gleichem Temperaturniveau.

Die vorliegende Erfindung betrifft schließlich die Verwendung mindestens einer Schaltungsanordnung gemäß der vorstehend dargelegten Art und/oder eines Verfahrens gemäß der vorstehend dargelegten Art in mindestens einem insbesondere fortbewegungsmittelgebundenen Rundfunkempfangsgerät, insbesondere in mindestens einem Autoradio, oder in mindestens einer Navigationseinrichtung.

### Kurze Beschreibung der Zeichnungen

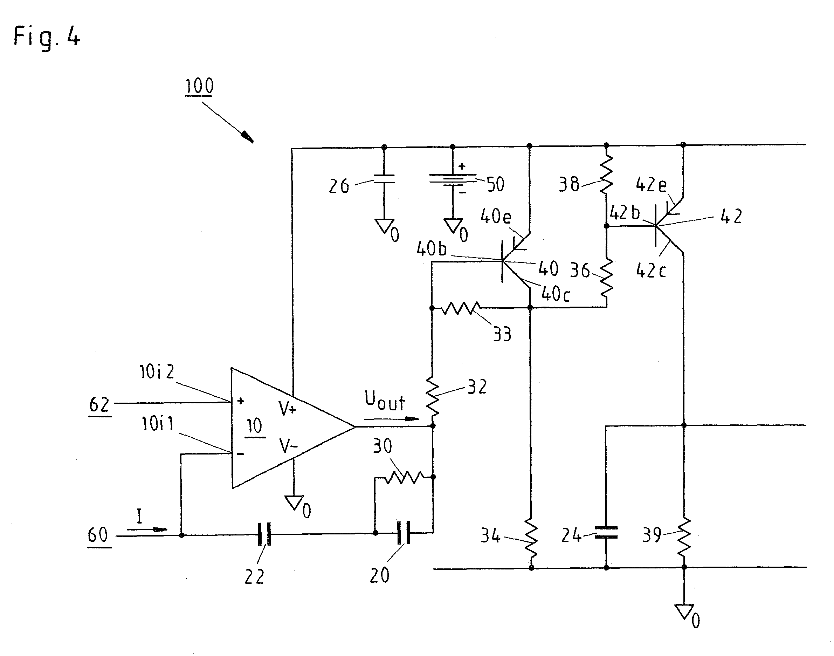

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie dem Anspruch 8 nachgeordneten Ansprüche verwiesen, andererseits werden weitere Ausgestaltungen, Merkmale und Vorteile der vorliegenden Erfindung nachstehend anhand der beiden durch die Figuren 4 bis 8 veranschaulichten Ausführungsbeispiele näher erläutert.

Es zeigt:
- Fig. 1: in schematischer Prinzipdarstellung ein Ausführungsbeispiel eines P[hase]L[ocked]L[oop]-Regelkreises aus dem Stand der Technik;
- Fig. 2: in schematischer Prinzipdarstellung ein Diagramm für einen ohne Spannungsbegrenzung und ohne nichtlineare Abstimmkennlinie, das heißt ohne Abstimmverzerrung erfolgenden Einschwingvorgang bei einem Frequenzsprung des P[hase]L[ocked]L[oop]-Regelkreises aus Fig. 1 von 108 Megahertz Empfangsfrequenz auf 87,5 Megahertz Empfangsfrequenz, wobei auf der Abszisse die Zeit in Millisekunden und auf der Ordinate die Spannung des Einschwingsignals in Volt aufgetragen ist;
- Fig. 3: in schematischer Prinzipdarstellung ein Diagramm für einen im Unterschied zu Figur 2 mit entsprechender Spannungsbegrenzung und mit nichtlinearer Abstimmkennlinie, das heißt mit Abstimmverzerrung erfolgenden Einschwingvorgang bei einem Frequenzsprung des P[hase]L[ocked]L[oop]-Regelkreises aus Fig. 1 von 108 Megahertz Empfangsfrequenz auf 87,5 Megahertz Empfangsfrequenz, wobei wiederum auf der Abszisse die Zeit in Millisekunden und auf der Ordinate die Spannung des Einschwingsignals in Volt aufgetragen ist;
- Fig. 4: in schematischer Prinzipdarstellung ein erstes Ausführungsbeispiel einer Schaltungsanordnung gemäß der vorliegenden Erfindung;
- Fig. 5: in schematischer Prinzipdarstellung ein zweites Ausführungsbeispiel einer Schaltungsanordnung gemäß der vorliegenden Erfindung;
- Fig.6: in schematischer Prinzipdarstellung ein Diagramm für eine nichtlineare Abstimmkennlinie sowie für eine korrespondierende, durch die Schaltungsanordnung aus Fig. 5 gebildete Entzerrkennlinie, wobei auf der Abszisse die Spannung des Einschwingsignals in Volt und auf der Ordinate die Empfangsfrequenz in Megahertz aufgetragen ist;
- Fig. 7: in schematischer Prinzipdarstellung das Diagramm aus Fig. 6 bei unterschiedlichen Betriebsspannungen von Ub = 8 Volt, von Ub = 8,5 Volt und von Ub = 9 Volt; und
- Fig. 8: in schematischer Prinzipdarstellung das Diagramm aus Fig. 6 bei unterschiedlichen Temperaturen von T = 30 Grad Celsius, von T = 50 Grad Celsius und von T = 70 Grad Celsius.

Gleiche oder ähnliche Ausgestaltungen, Elemente oder Merkmale sind in den Figuren 1 bis 8 mit identischen Bezugszeichen versehen.

### Bester Weg zur Ausführung der Erfindung

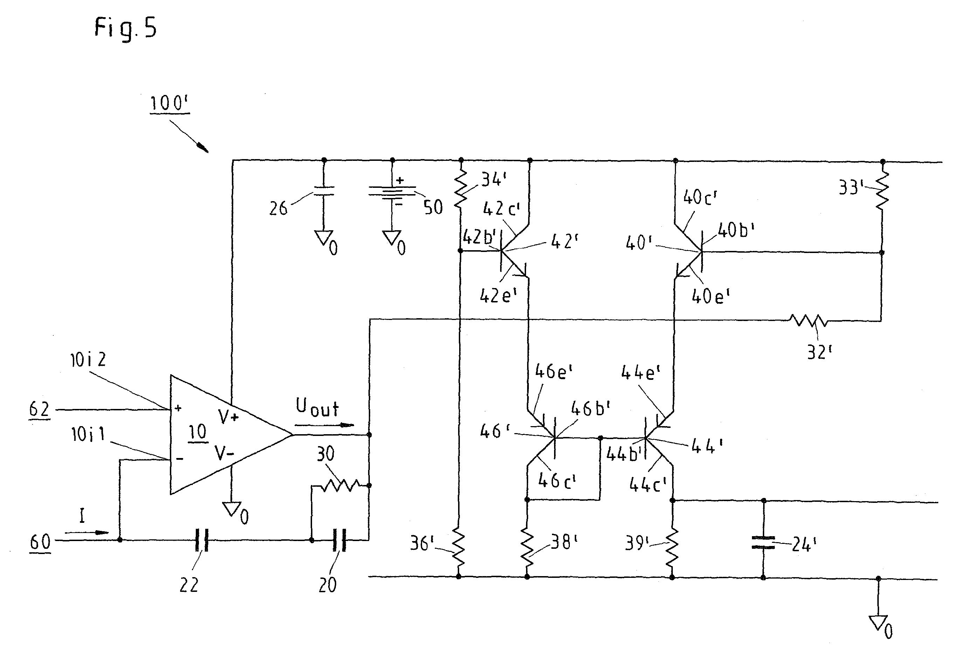

Das anhand Figur 4 veranschaulichte erste Ausführungsbeispiel sowie das anhand Figur 5 veranschaulichte zweite Ausführungsbeispiel einer beispielsweise in der auf R[adio]D[aten]S[ystem]-Basis arbeitenden F[requenz]M[odulation]-Empfangseinheit eines Autoradios integrierten Schaltungsanordnung 100 gemäß der vorliegenden Erfindung dient zum verfahrensmäßigen Abstimmen, Einstellen bzw. Steuern der Oszillatorfrequenz.

Auszugehen ist hierbei von einem P[hase]L[ocked]L[oop]-Regelkreis, das heißt von einem Schleifenfilter, das für ein PLL-System mit einem Referenztakt von etwa fünfzig Kilohertz und mit einem Pumpstrom von etwa ±2 Milliampere ausgelegt ist.

Das Schleifenfilter ist hierbei in Figur 4 bzw. in Figur 5 dadurch gegeben, daß dem Ausgangsanschluß 10o der Operationsverstärkereinheit 10 (sogenannter "rail-to-rail"-Typ) ein erstes kapazitives Element 20 (mit einer Kapazität von zum Beispiel etwa 360 Picofarad) nachgeschaltet ist, zu dem ein erstes Widerstandselement 30 (= zum Beispiel etwa 10,5 Kiloohm) parallel geschaltet ist.

Diesem ersten kapazitiven Element 20 ist ein zweites kapazitives Element 22 (mit einer Kapazität von zum Beispiel etwa 5,1 Nanofarad) nachgeschaltet, das sowohl mit dem Pumpstromeingang 60 für den Pumpstrom I (= zum Beispiel etwa ±2 Milliampere) als auch mit dem negativen Eingangsanschluß 10i1 der Operationsverstärkereinheit 10 verbunden ist.

Das Schleifenfilter weist einen Phasenrandwinkel von 61,5 Grad und eine Eigenfrequenz von 53.000/(2π) = 8.435 Hertz auf; wie bereits erwähnt, ist das Schleifenfilter für ein auf R[adio]D[aten]S[ystem]-Basis arbeitendes F[requenz]M[odulation]-Empfängersystem mit sehr schnellen Frequenzsprüngen vorgesehen.

Wird nun dieses Schleifenfilter zum Gewährleisten dieser sehr schnellen Frequenzsprünge erfindungsgemäß mit einer Linearisierungsschaltung verknüpft, so ergibt sich die gesamte Schaltungsanordnung 100 gemäß Figur 4 bzw. die gesamte Schaltungsanordnung 100' gemäß Figur 5.

Hierbei wird dem P[hase]L[ocked]L[oop]-Regelkreis 10, 20, 30, 22 die Linearisierungsschaltung zugeordnet, das heißt nachgeschaltet, um die als Differentialquotient aus Empfangsfrequenz f und Spannung U des Abstimmsignals gegebene Abstimmkennlinie zu linearisieren.

Gemäß der Lehre der vorliegenden Erfindung bedeutet dies, daß beim ersten Ausführungsbeispiel der Schaltungsanordnung 100 gemäß Figur 4 die (ursprüngliche) Schaltung des Schleifenfilters
- um einen dritten Kondensator 24
   (mit einer Kapazität von zum Beispiel etwa 82 Picofarad),
- um einen zweiten Widerstand 32
   (= zum Beispiel etwa zehn Kiloohm),
- um einen dritten Widerstand 33
   (= zum Beispiel etwa 9,1 Kiloohm),
- um einen vierten Widerstand 34
   (= zum Beispiel etwa 5,6 Kiloohm),
- um einen fünften Widerstand 36
   (= zum Beispiel etwa 9,1 Kiloohm),
- um einen sechsten Widerstand 38
   (= zum Beispiel etwa zehn Kiloohm) und
- um einen siebten Widerstand 39
   (= zum Beispiel etwa 8,2 Kiloohm) sowie
- um einen ersten pnp-Transistor 40 und
- um einen zweiten pnp-Transistor 42
erweitert wird.

Wie aus Figur 4 hervorgeht, wird beim ersten Ausführungsbeispiel der Schaltungsanordnung 100 der Input (zweites Widerstandselement 32) mit dem Schleifenfilter verbunden, das heißt dem Ausgangsanschluß 10o der Operationsverstärkereinheit 10 wird das zweite Widerstandselement 32 nachgeschaltet; dieses zweite Widerstandselement 32 ist mit dem dritten Widerstandselement 33 sowie mit dem Basisanschluß 40b der ersten Transistoreinheit 40 verbunden.

Der Kollektoranschluß 40c der ersten Transistoreinheit 40 sowie das dritte Widerstandselement 33 sind sowohl mit dem vierten Widerstandselement 34 als auch mit dem fünften Widerstandselement 36 zusammengeschaltet, wobei das fünfte Widerstandselement 36 wiederum mit dem sechsten Widerstandselement 38 sowie mit dem Basisanschluß 42b der zweiten Transistoreinheit 42 verbunden ist.

Der Darstellung gemäß Figur 4 ist des weiteren entnehmbar, daß beim ersten Ausführungsbeispiel der Schaltungsanordnung 100 der Emitteranschluß 42e der zweiten Transistoreinheit 42
- mit dem sechsten Widerstandselement 38,
- mit dem Emitteranschluß 40e der ersten Transistoreinheit 40,
- mit einer Gleichspannungsquelle 50 (= zum Beispiel etwa V = 8,5 Volt),
- mit einem vierten kapazitiven Element 26 (mit einer Kapazität von zum Beispiel etwa 47 Nanofarad), das im Grunde genommen dem ursprünglichen Schleifenfilter zuzurechnen ist, sowie
- mit dem positiven Betriebsspannungseingang V+ der Operationsverstärkereinheit 10
verbunden ist.

In Figur 4 ist des weiteren dargestellt, daß beim ersten Ausführungsbeispiel der Schaltungsanordnung 100 der Kollektoranschluß 42c der zweiten Transistoreinheit 42 mit dem dritten kapazitiven Element 24 sowie mit einem zu diesem dritten kapazitiven Element 24 parallel geschalteten siebten Widerstandselement 39 verbunden ist, wobei das dritte kapazitive Element 24 und das siebte Widerstandselement 39 mit dem vierten Widerstandselement 34 zusammengeschaltet sind.

Der Output (drittes kapazitives Element 24 und parallel geschaltetes siebtes Widerstandselement 39) wird über in Figur 4 aus Gründen der Übersichtlichkeit der Darstellung nicht explizit gezeigte Entkopplungswiderstände den Kapazitätsdioden zugeführt (für Oszillatorund Eingangskreis). Das dritte kapazitive Element 24 und das parallel geschaltete siebte Widerstandselement 39 bilden hierbei das sogenannte "Nachfilter".

Beim zweiten Ausführungsbeispiel der Schaltungsanordnung 100' gemäß Figur 5 wird die (ursprüngliche) Schaltung des Schleifenfilters
- um einen dritten Kondensator 24'
   (mit einer Kapazität von zum Beispiel etwa einhundert Picofarad),
- um einen zweiten Widerstand 32'
   (= zum Beispiel etwa 5,8 Kiloohm),
- um einen dritten Widerstand 33'
   (= zum Beispiel etwa einhundert Kiloohm),
- um einen vierten Widerstand 34'
   (= zum Beispiel etwa einhundert Kiloohm),
- um einen fünften Widerstand 36'
   (= zum Beispiel etwa zwölf Kiloohm),
- um einen sechsten Widerstand 38'
   (= zum Beispiel etwa zwölf Kiloohm) und
- um einen siebten Widerstand 39'
   (= zum Beispiel etwa sechs Kiloohm) sowie
- um einen ersten npn-Transistor 40',
- um einen zweiten npn-Transistor 42',
- um einen dritten pnp-Transistor 44' und
- um einen vierten pnp-Transistor 46'
erweitert wird.

Wie aus Figur 5 hervorgeht, wird auch beim zweiten Ausführungsbeispiel der Schaltungsanordnung 100' der Input (zweites Widerstandselement 32') mit dem Schleifenfilter verbunden, das heißt dem Ausgangsanschluß 10o der Operationsverstärkereinheit 10 wird das zweite Widerstandselement 32' nachgeschaltet; dieses zweite Widerstandselement 32' ist mit dem dritten Widerstandselement 33' sowie mit dem Basisanschluß 40b' der ersten Transistoreinheit 40' verbunden.

Der Kollektoranschluß 40c' der ersten Transistoreinheit 40' sowie das dritte Widerstandselement 33' sind
- mit dem Kollektoranschluß 42c' der zweiten Transistoreinheit 42',
- mit dem vierten Widerstandselement 34',
- mit einer Gleichspannungsquelle 50 (= zum Beispiel etwa V = 8,5 Volt),
- mit einem vierten kapazitiven Element 26 (mit einer Kapazität von zum Beispiel etwa 47 Nanofarad), das im Grunde genommen dem ursprünglichen Schleifenfilter zuzurechnen ist, sowie
- mit dem positiven Betriebsspannungseingang V+ der Operationsverstärkereinheit 10
verbunden.

Der Darstellung gemäß Figur 5 ist des weiteren entnehmbar, daß beim zweiten Ausführungsbeispiel der Schaltungsanordnung 100' der Basisanschluß 42b' der zweiten Transistoreinheit 42' sowohl mit dem vierten Widerstandselement 34' als auch mit dem fünften Widerstandselement 36' zusammengeschaltet ist. Des weiteren ist der Emitteranschluß 40e' der ersten Transistoreinheit 40' mit dem Emitteranschluß 44e' der dritten Transistoreinheit 44' verbunden.

In Figur 5 ist des weiteren dargestellt, daß beim zweiten Ausführungsbeispiel der Schaltungsanordnung 100' der Emitteranschluß 42e' der zweiten Transistoreinheit 42' mit dem Emitteranschluß 46e' der vierten Transistoreinheit 46' verbunden ist. Der Basisanschluß 44b' der dritten Transistoreinheit 44' ist
- mit dem Basisanschluß 46b' der vierten Transistoreinheit 46',
- mit dem Kollektoranschluß 46c' der vierten Transistoreinheit 46' sowie
- mit dem sechsten Widerstandselement 38'
zusammengeschaltet.

Der Kollektoranschluß 44c' der dritten Transistoreinheit 44' mit dem dritten kapazitiven Element 24' sowie mit dem zu diesem dritten kapazitiven Element 24' parallel geschalteten siebten Widerstandselement 39' verbunden, wobei das dritte kapazitive Element 24' und das siebte Widerstandselement 39' mit dem fünften Widerstandselement 36' sowie mit dem sechsten Widerstandselement 38' zusammengeschaltet sind.

Der Output (drittes kapazitives Element 24' und parallel geschaltetes siebtes Widerstandselement 39') wird über in Figur 5 aus Gründen der Übersichtlichkeit der Darstellung nicht explizit gezeigte Entkopplungswiderstände den Kapazitätsdioden zugeführt (für Oszillatorund Eingangskreis). Das dritte kapazitive Element 24' und das parallel geschaltete siebte Widerstandselement 39' bilden hierbei das sogenannte "Nachfilter".

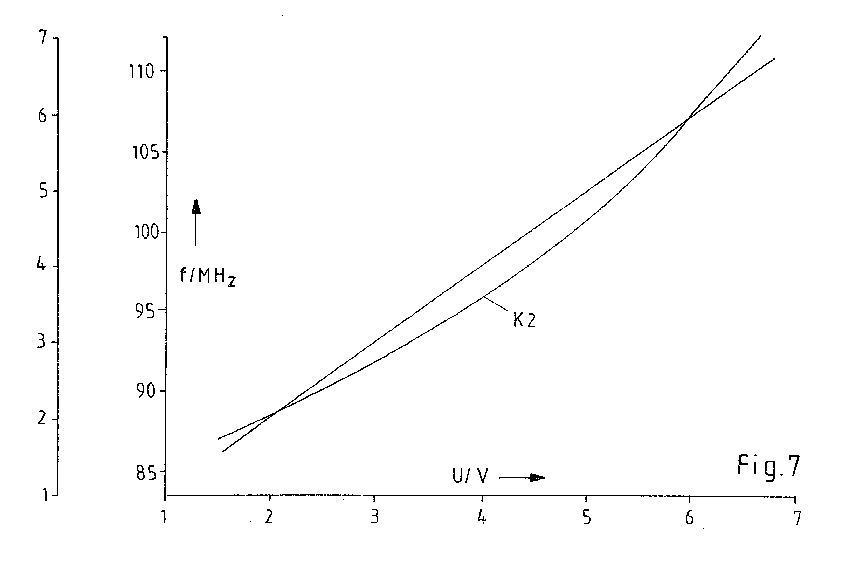

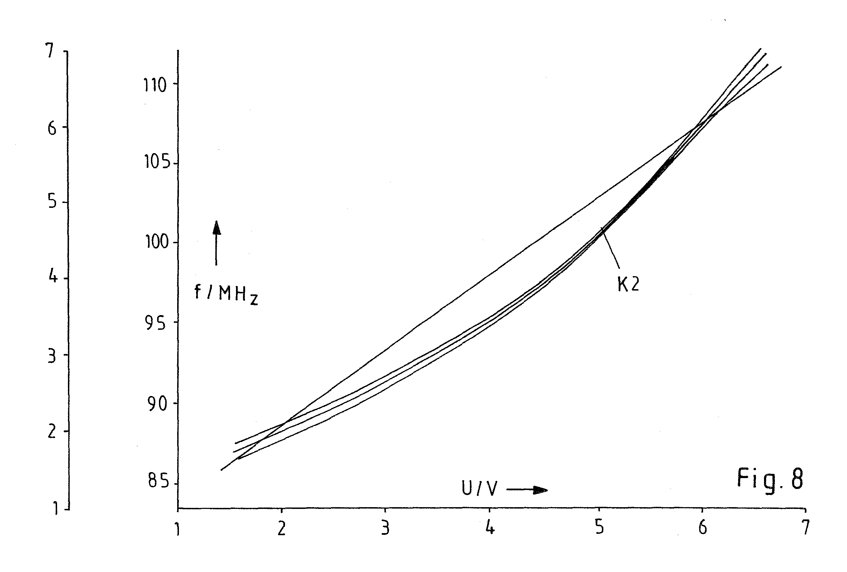

Das zweite Ausführungsbeispiel der Schaltungsanordnung 100' gemäß Figur 5 ist in bezug auf Änderungen der Betriebsspannung Ub (vgl. Figur 7) sehr unkritisch und gegen Temperatureinflüsse (vgl. Figur 8) unempfindlich, so daß diese Schaltungsanordnung 100' aus Stabilitätsgründen sehr empfehlenswert ist.

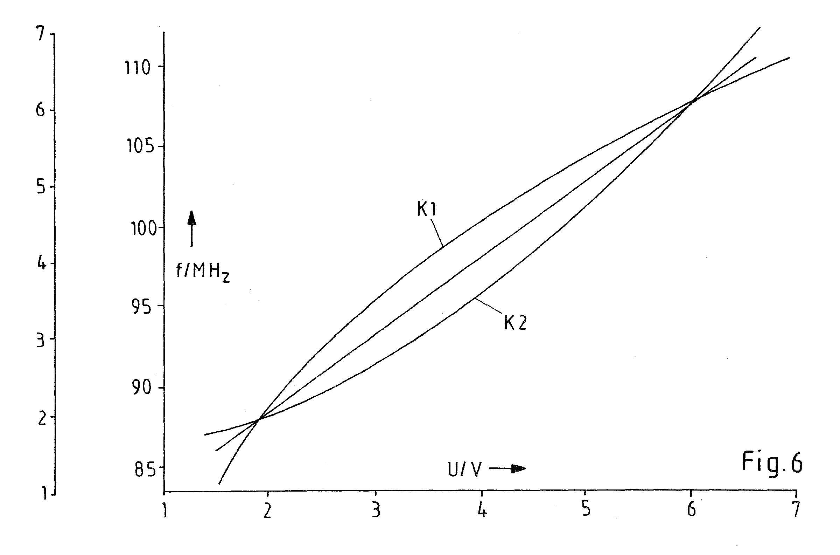

In Figur 6 ist eine mögliche Abstimmkennlinie K1 dargestellt; die hierzu entsprechende Entzerrkennlinie K2 ist durch die Schaltungsanordnung 100' gemäß Figur 5 gegeben. Die Vorgehensweise bei der Anwendung der Linearisierung ist hierbei folgendermaßen:

Zunächst wird die Abstimmkennlinie K1 des gegebenen Empfängersystems aufgenommen (und zwar möglichst um etwa ein Volt über die Bandgrenzen hinaus); dann wird die Umkehrfunktion in Form der Entzerrkurve K2 gebildet. Diese Umkehrfunktion K2, die praktischerweise die Linearisierung der Abstimmkennlinie K1 repräsentiert, wird durch entsprechende Dimensionierung
- des zweiten Widerstandselements 32 bzw. 32',
- des dritten Widerstandselements 33 bzw. 33',
- des vierten Widerstandselements 34 bzw. 34',
- des fünften Widerstandselements 36 bzw. 36',
- des sechsten Widerstandselements 38 bzw. 38' und
- des siebten Widerstandselements 39 bzw. 39'
in der Schaltungsanordnung 100 bzw. 100' nachgebildet, wobei in den meisten Fällen nur eine leichte Anpassung erforderlich ist.

Sowohl in der Schaltungsanordnung 100 als auch in der Schaltungsanordnung 100' befinden sich die Transistoren 40, 42 bzw. die Transistoren 40', 42', 44', 46' während des Betriebs in etwa auf gleichem Temperaturniveau.

Wie den Figuren 6, 7 und 8 entnehmbar ist, können mittels der dem Phasenregelkreis erfindungsgemäß zugeordneten Linearisierungsschaltung, das heißt dadurch, daß die als Differentialquotient aus Empfangsfrequenz f und Spannung U des Abstimmsignals gegebene Abstimmkennlinie verfahrensgemäß linearisiert wird, Einschwingzeiten von weniger als 0,2 Millisekunden verwirklicht werden.

Dies stellt im Vergleich zum Stand der Technik eine beachtliche Verbesserung mit verhältnismäßig geringem Aufwand dar (unter gleichen Bedingungen sind konventionellerweise, das heißt ohne die vorbeschriebene Abstimmlinearisierung lediglich Einschwingzeiten von etwa zwei Millisekunden möglich). Die Dimensionierung der P[hase]L[ocked]L[oop] bzw. des Schleifenfilters ist im wesentlichen dieselbe wie ohne Abstimmlinearisierung, das heißt gemäß dem Stand der Technik.

Die vorliegende Erfindung ist durch PSpice-P[hase]L[ocked]L[oop]-Simulationen (--> Kapazitäten C sind mit Faktor 1.000 zu versehen; Zeiten t sind mit Faktor 1.000 zu versehen) und auch in F[requenz]M[odulation]-Empfängern gut nachweisbar.

Praktischerweise kann die vorliegende, anhand der beiden Ausführungsbeispiele der Figuren 4 und 5 veranschaulichte Erfindung in Autoradio-F[requenz]M[odulation]-Empfängern mit R[adio]D[aten]S[ystem] (A[lternative]F[requency]-Tests) eingesetzt bzw. direkt in P[hase]L[ocked]L[oop]-I[ntegrated]C[ircuit]s integriert werden.

## Patentansprüche

1. Zum Abstimmen der Oszillationsfrequenz in mindestens einer Empfangseinheit vorgesehene Schaltungsanordnung (100; 100'), aufweisend mindestens einen Phasenregelkreis, insbesondere mindestens einen P[hase]L[ocked]L[oop]-Regelkreis, mit mindestens einer Operationsverstärkereinheit (10),
**dadurch gekennzeichnet,**
**daß** dem Phasenregelkreis mindestens eine Linearisierungsschaltung zugeordnet, insbesondere nachgeschaltet, ist, mittels derer die insbesondere als aus Empfangsfrequenz (f) und Spannung (U) des Abstimmsignals gebildeter Differentialquotient gegebene Abstimmkennlinie (K1) linearisierbar ist.

2. Schaltungsanordnung gemäß Anspruch 1, **dadurch gekennzeichnet, daß** beim Phasenregelkreis
- dem Ausgangsanschluß (10o) der Operationsverstärkereinheit (10) mindestens ein erstes kapazitives Element (20) nachgeschaltet ist, zu dem mindestens ein erstes Widerstandselement (30) parallel geschaltet ist, und
- dem ersten kapazitiven Element (20) mindestens ein zweites kapazitives Element (22) nachgeschaltet ist, das sowohl mit mindestens einem Pumpstromeingang (60) als auch mit dem negativen Eingangsanschluß (10i1 ) der Operationsverstärkereinheit (10) verbunden ist.

3. Schaltungsanordnung gemäß Anspruch 1 oder 2, **dadurch gekennzeichnet,**
- **daß** dem Ausgangsanschluß (10o) der Operationsverstärkereinheit (10) mindestens ein zweites Widerstandselement (32) nachgeschaltet ist, das mit mindestens einem dritten Widerstandselement (33) sowie mit dem Basisanschluß (40b) mindestens einer ersten Transistoreinheit (40), insbesondere mindestens einer pnp-Transistoreinheit, verbunden ist,
- **daß** der Kollektoranschluß (40c) der ersten Transistoreinheit (40) sowie das dritte Widerstandselement (33) sowohl mit mindestens einem vierten Widerstandselement (34) als auch mit mindestens einem fünften Widerstandselement (36) zusammengeschaltet sind und
- **daß** das fünfte Widerstandselement (36) mit mindestens einem sechsten Widerstandselement (38) sowie mit dem Basisanschluß (42b) mindestens einer zweiten Transistoreinheit (42), insbesondere mindestens einer pnp-Transistoreinheit, verbunden ist.

4. Schaltungsanordnung gemäß Anspruch 3, **dadurch gekennzeichnet,**
- **daß** der Emitteranschluß (42e) der zweiten Transistoreinheit (42)
-- mit dem sechsten Widerstandselement (38),
-- mit dem Emitteranschluß (40e) der ersten Transistoreinheit (40),
-- mit mindestens einer Gleichspannungsquelle (50),
-- mit mindestens einem vierten kapazitiven Element (26) sowie
-- mit dem positiven Betriebsspannungseingang (V+) der Operationsverstärkereinheit (10)
verbunden ist und
- daß der Kollektoranschluß (42c) der zweiten Transistoreinheit (42) mit mindestens einem dritten kapazitiven Element (24) sowie mit mindestens einem zu diesem dritten kapazitiven Element (24) parallel geschalteten siebten Widerstandselement (39) verbunden ist, wobei das dritte kapazitive Element (24) und das siebte Widerstandselement (39) mit dem vierten Widerstandselement (34) zusammengeschaltet sind.

5. Schaltungsanordnung gemäß Anspruch 1 oder 2, **dadurch gekennzeichnet,**
- **daß** dem Ausgangsanschluß (10o) der Operationsverstärkereinheit (10) mindestens ein zweites Widerstandselement (32') nachgeschaltet ist, das mit mindestens einem dritten Widerstandselement (33') sowie mit dem Basisanschluß (40b') mindestens einer ersten Transistoreinheit (40'), insbesondere mindestens einer npn-Transistoreinheit, verbunden ist, und
- **daß** der Kollektoranschluß (40c') der ersten Transistoreinheit (40') sowie das dritte Widerstandselement (33')
-- mit dem Kollektoranschluß (42c') mindestens einer zweiten Transistoreinheit (42'), insbesondere mindestens einer npn-Transistoreinheit,
-- mit mindestens einem vierten Widerstandselement (34'),
-- mit mindestens einer Gleichspannungsquelle (50),
-- mit mindestens einem vierten kapazitiven Element (26) sowie
-- mit dem positiven Betriebsspannungseingang (V+) der Operationsverstärkereinheit (10)
verbunden sind.

6. Schaltungsanordnung gemäß Anspruch 5, **dadurch gekennzeichnet,**
- **daß** der Basisanschluß (42b') der zweiten Transistoreinheit (42') sowohl mit dem vierten Widerstandselement (34') als auch mit mindestens einem fünften Widerstandselement (36') zusammengeschaltet ist,
- **daß** der Emitteranschluß (40e') der ersten Transistoreinheit (40') mit dem Emitteranschluß (44e') mindestens einer dritten Transistoreinheit (44'), insbesondere mindestens einer pnp-Transistoreinheit, verbunden ist und
- **daß** der Emitteranschluß (42e') der zweiten Transistoreinheit (42') mit dem Emitteranschluß (46e') mindestens einer vierten Transistoreinheit (46'), insbesondere mindestens einer pnp-Transistoreinheit, verbunden ist.

7. Schaltungsanordnung gemäß Anspruch 5 oder 6, **dadurch gekennzeichnet,**
- **daß** der Basisanschluß (44b') der dritten Transistoreinheit (44')
-- mit dem Basisanschluß (46b') der vierten Transistoreinheit (46'),
-- mit dem Kollektoranschluß (46c') der vierten Transistoreinheit (46') sowie
-- mit mindestens einem sechsten Widerstandselement (38') zusammengeschaltet ist und
- daß der Kollektoranschluß (44c') der dritten Transistoreinheit (44') mit mindestens einem dritten kapazitiven Element (24') sowie mit mindestens einem zu diesem dritten kapazitiven Element (24') parallel geschalteten siebten Widerstandselement (39') verbunden ist, wobei das dritte kapazitive Element (24') und das siebte Widerstandselement (39') mit dem fünften Widerstandselement (36') sowie mit dem sechsten Widerstandselement (38') zusammengeschaltet sind.

8. Verfahren zum Abstimmen der Oszillationsfrequenz in mindestens einer Empfangseinheit,
**dadurch gekennzeichnet,**
**daß** mindestens einem Phasenregelkreis, insbesondere mindestens einem P[hase]L[ocked]L[oop]-Regelkreis, mindestens eine Linearisierungsschaltung zugeordnet, insbesondere nachgeschaltet, wird, mittels derer die insbesondere als aus Empfangsfrequenz (f) und Spannung (U) des Abstimmsignals gebildeter Differentialquotient gegebene Abstimmkennlinie (K1) linearisiert wird.

9. Verfahren gemäß Anspruch 8, **dadurch gekennzeichnet, daß** zum Linearisieren der Abstimmkennlinie (K1)
[i] die nichtlineare Abstimmkennlinie (K1) aufgenommen wird und
[ii] die der linearisierten Abstimmkennlinie entsprechende Umkehrfunktion (K2) der nichtlinearen Abstimmkennlinie (K1) durch entsprechendes Dimensionieren
- mindestens eines zweiten Widerstandselements (32; 32'),
- mindestens eines dritten Widerstandselements (33; 33'),
- mindestens eines vierten Widerstandselements (34; 34'),
- mindestens eines fünften Widerstandselements (36; 36'),
- mindestens eines sechsten Widerstandselements (38; 38') und
- mindestens eines siebten Widerstandselements (39; 39'),
nachgebildet wird.

10. Verwendung mindestens einer Schaltungsanordnung (100; 100') gemäß mindestens einem der Ansprüche 1 bis 8 und/oder eines Verfahrens gemäß Anspruch 9 in mindestens einem insbesondere fortbewegungsmittelgebundenen Rundfunkempfangsgerät, insbesondere in mindestens einem Autoradio, oder in mindestens einer Navigationseinrichtung.
